(19) Europäisches Patentamt
European Patent Office
Office européen des brevets

(11) **EP 1 882 007 B1**

(12) **EUROPEAN PATENT SPECIFICATION**

(45) Date of publication and mention
of the grant of the patent:
**14.12.2011 Bulletin 2011/50**

(51) Int Cl.:
*C08J 7/18* (2006.01)  *B05D 7/24* (2006.01)
*B32B 27/32* (2006.01)

(21) Application number: **06749667.9**

(22) Date of filing: **10.04.2006**

(86) International application number:
**PCT/US2006/013333**

(87) International publication number:
**WO 2006/121556 (16.11.2006 Gazette 2006/46)**

(54) **PROCESS FOR PLASMA COATING A POLYPROPYLENE OBJECT**

VERFAHREN ZUM PLASMABESCHICHTEN EINES POLYPROPYLENOBJEKTS

PROCEDE DE REVETEMENT PAR PROJECTION PLASMA D'UN OBJET EN POLYPROPYLENE

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **06.05.2005 US 678479 P
09.06.2005 US 688950 P**

(43) Date of publication of application:
**30.01.2008 Bulletin 2008/05**

(73) Proprietor: **Dow Global Technologies LLC
Midland, MI 48674 (US)**

(72) Inventors:
• **WEIKART, Christopher, M.**
**Midland, Michigan 48640 (US)**
• **PHAM, Hoang, T.**
**Lake Jackson, Texas 77566 (US)**
• **GLASS, Terry, W.**
**Richwood, Texas 77531 (US)**

(74) Representative: **Hayes, Adrian Chetwynd
Boult Wade Tennant
Verulam Gardens
70 Gray's Inn Road
London WC1X 8BT (GB)**

(56) References cited:
**EP-A1- 0 566 053     US-A1- 2004 149 225**

• **DATABASE CA [Online] CHEMICAL ABSTRACTS
SERVICE, COLUMBUS, OHIO, US; HASHIMOTO,
KOKICHI ET AL: "Undrawn polypropylene
composite films for metal vapor deposition"
XP002404154 retrieved from STN Database
accession no. 1996:138113 & JP 07 329259 A2
(TORAY INDUSTRIES, JAPAN) 19 December 1995
(1995-12-19)**
• **DATABASE WPI Week 198431 Derwent
Publications Ltd., London, GB; AN 1984-192379
XP002404166 & JP 59 109530 A (MITSUBISHI
PETROCHEMICAL CO LTD) 25 June 1984
(1984-06-25)**

**Description**

Polypropylene has been plasma coated. However, prior art plasma coatings on a polypropylene surface are not as adherent as desired. It would be an advance in the art if a plasma coating process were discovered that produced a more adherent coating.

The instant invention is a solution, at least in part, to the above-stated problem. More specifically, the instant invention is a process for preparing a coating on an object, the coating having a cross-hatch adhesion ranking of better than 3 according to the ASTM D-3359 test. The process comprises the steps of: (a) plasma polymerizing an organosilicon compound under conditions to deposit a polyorganosiloxane layer onto the object, the polyorganosiloxane layer being thicker than 5nm; and/or (b) plasma polymerizing a organosilicon compound under conditions to deposit a silicon oxide layer directly on the object or onto a polyorganosiloxane layer prepared according to step (a), the silicon oxide layer being thicker than 5nm wherein the object comprises a polymer composition comprising (i) from 99 to 50 weight percent of a polymer having more than 90 weight percent monomer units containing three carbons and optionally monomer units selected from the group consisting of alpha olefins containing two carbons and/or from four to twelve carbons, and (ii) from 1 to 50 weight percent of a second copolymer comprising monomer units selected from the group consisting of alpha olefins containing two carbons and alpha olefins containing from four to twelve carbons and optionally up to 10 weight percent of a diene monomer containing less than thirteen carbons; or the object comprises an alternative polymer composition comprising (iii) from 1 to 50 weight percent of a copolymer of propylene and up to 10 weight percent of a comonomer selected from the group consisting of alpha olefins containing two carbons and/or from four to twelve carbons, and (iv) from 99 to 50 weight percent of an impact copolymer consisting of a blend of homopolymer polypropylene with up to 50 weight percent of a random copolymer of propylene and an alpha olefin containing two carbons and/or from four to twelve carbons.

In another embodiment, the instant invention is an article of manufacture, comprising: a body comprising a polymer composition comprising (i) from 99 to 50 weight percent of a polymer having more than 90 weight percent monomer units containing three carbons and optionally monomer units selected from the group consisting of alpha olefins containing two carbons and/or from four to twelve carbons, and (ii) from 1 to 50 weight percent of a second copolymer comprising monomer units selected from the group consisting of alpha olefins containing two carbons and alpha olefins containing from four to twelve carbons and optionally up to 10 weight percent of a diene monomer containing less than thirteen carbons; or the body comprising an alternative polymer composition comprising (iii) from 1 to 50 weight percent of a copolymer of propylene and up to 10 weight percent of a comonomer selected from the group consisting of alpha olefins containing two carbons and/or from four to twelve carbons, and (iv) from 99 to 50 weight percent of an impact copolymer consisting of a blend of homopolymer polypropylene with up to 50 weight percent of a random copolymer of propylene and an alpha olefin containing two carbons and/or from four to twelve carbons; the article further comprising a coating on the body wherein the coating comprises a polyorganosiloxane layer thicker than 5nm, or a silicon oxide layer thicker than 10nm, or a silicon oxide layer thicker than 10nm superposing a polyorganosiloxane layer thicker than 5nm, wherein the article has a cross-hatch adhesion ranking according to the ASTM D-3359 test of the polyorganosiloxane layer, the silicon oxide layer or both on the body of greater than 3.

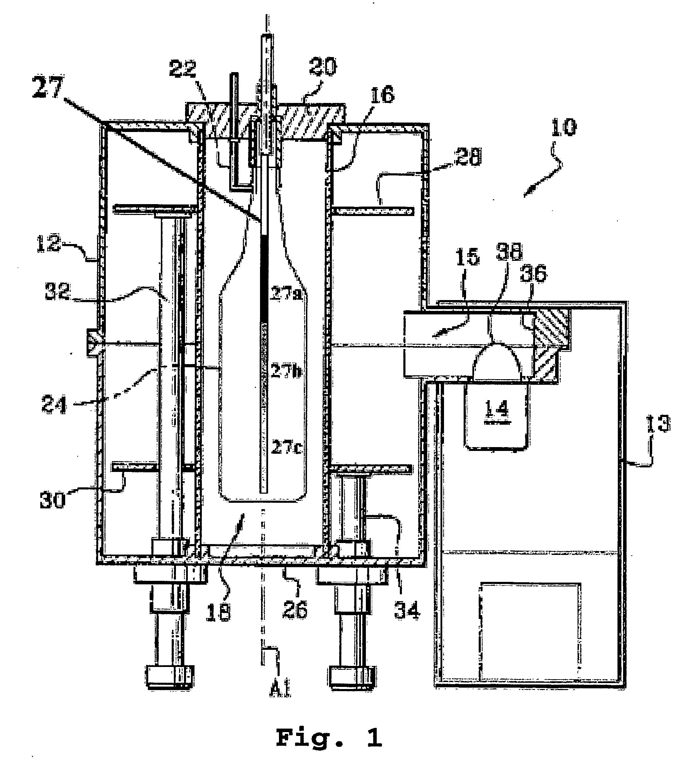

Fig. 1 is an illustration of an apparatus used to coat the inside of a container using the method of the instant invention.

The process of the present invention when used to coat the inside of a container (such as a bottle) is advantageously, though not uniquely, carried out using any of the microwave plasma coating apparatus described in WO0310012 and WO0066804 or RF plasma coating apparatus in wü9815669. The apparatus in WO0066804 is reproduced with some modification in FIG. 1 and with specific regard to the polyorganosiloxane and/or silicon oxide coating process, the apparatus and method described in United States Patent Application Publication 2004/0149225 A1 (both of which are herein fully incorporated by reference). The apparatus 10 has an external conducting resonant cavity 12, which is preferably cylindrical (also referred to as an external conducting resonant cylinder having a cavity). Apparatus 10 includes a generator 14 that is connected to the outside of resonant cavity 12. The generator 14 is capable of providing an electromagnetic field in the microwave region, more particularly, a field corresponding to a frequency of 2.45 GHz. Generator 14 is mounted on box 13 on the outside of resonant cavity 12 and the electromagnetic radiation it delivers is taken up to resonant cavity 12 by a wave guide 15 that is substantially perpendicular to axis A1 and which extends along the radius of the resonant cavity 12 and emerges through a window located inside the resonant cavity 12. Tube 16 is a hollow cylinder transparent to microwaves located inside resonant cavity 12. Tube 16 is closed on one end by a wall 26 and open on the other end to permit the introduction of a container 24 to be treated by PECVD.

A detailed discussion will now be made for a number of pages with regard to the polymer compositions of the instant invention and then the discussion in relation to the apparatus of Fig. 1 will resume. Container 24 is a container comprising a polymer composition comprising (i) from 99 to 50 weight percent of a polymer having more than 90 weight percent monomer units containing three carbons and optionally monomer units selected from the group consisting of alpha olefins containing two carbons and/or from four to twelve carbons, and (ii) from 1 to 50 weight percent of a second copolymer comprising monomer units selected from the group consisting of alpha olefins containing two carbons and alpha olefins containing from four to twelve carbons and optionally up to 10 weight percent of a diene monomer containing less than thirteen carbons; or the object comprises an alternative polymer composition comprising (iii) from 1 to 50 weight percent of a copolymer of propylene and up to 10 weight percent of a comonomer selected from the group consisting of alpha olefins containing two carbons and/or from four to twelve carbons, and (iv) from 99 to 50 weight percent of an impact copolymer consisting of a blend of homopolymer polypropylene with up to 50 weight percent of a random copolymer of propylene and an alpha olefin containing two carbons and/or from four to twelve carbons.

When component (i) is present and comprises from 99 to 50 weight percent of a polymer comprising more than 90 weight percent monomer units containing three carbons and optionally monomer units selected from the group consisting of alpha olefins containing two carbons and/or from four to twelve carbons, then the following are preferred: The density of the component (ii) is preferably in the range of from 0.854 to 0.92 grams per cubic centimeter; The melt index of the component (ii) is preferably less than 100 (and more preferably less than 50) as determined by ASTM method D 1238-01 at 190 degrees Celsius with a 2.16 Kg. weight; The amount of the component (ii) is preferably in the range of from 5 to 30 weight percent of the polymer composition of the instant invention; and most preferably, component (ii) is an ethylene/octene copolymer. Preferably, the degree of crystallinity of component (i) is greater than 65 percent (more preferably greater than 68 percent and even more preferably greater than 70 percent).

When component (iv) is present and comprises an impact copolymer consisting of a blend of homopolymer of polypropylene with up to 50 weight percent of a random copolymer of propylene and an alpha olefin derived from the group consisting of alpha olefins containing two carbons and/or from four to twelve carbons, then the following are preferred: The amount of component (iii) is preferably from 5 to 50 weight percent of the polymer composition of the instant invention; the propylene content of component (iv) is preferably between 5 and 85 weight percent; the melt index of component (iv) is preferably less than 50 as determined by ASTM method D 1238-01 at 190 degrees Celsius with a 2.16 Kg. weight; and preferably the melt flow ratio of component (iv) to component (iii) is between 0.1 and 5 (and more preferably between 0.3 and 3).

A preferred polymer composition of the instant invention comprises a blend of a high crystalline polypropylene with an impact modifier. The impact modifier improves the toughness and impact strength of the composition. The impact modifier preferably is a polyolefin rubber, which exhibits a glass transition temperature of less than -20 degrees Celsius. The impact modifier preferably makes up no greater than 50 percent by weight of the composition.

The impact modifiers include ethylene/alpha-olefin copolymers and terpolymers and block copolymers, ethylene-propylene diene rubbers, propylene-alpha olefin copolymers, silicon rubbers, butadiene-based rubber and the like. The more preferred impact modifiers are ethylene/alpha-olefin copolymers made with single-site or metallocene catalysts wherein the units within the impact modifier derived from ethylene are greater than 50 percent by weight and the alpha-olefin is selected from olefins having at least three carbon atoms, preferably at least 4 carbon atoms, more preferably from 4 to 12 carbon atoms, further more preferably from 4 to 8 carbon atoms. The even more preferred alpha-olefins are 1-butene, 1-hexene, 1-heptene, 1-octene and even a styrenic such as styrene. The most preferred alpha-olefin is 1-octane.

The impact modifiers preferably have a density of from 0.854 to 0.91 $g/cm^3$ For ease of handling, the impact modifier preferably has a density greater than 0.865 $g/cm^3$

In applications requiring greater impact, the impact modifier preferably has a density of from 0.865 $g/cm^3$ to 0.88 $g/cm^3$. For applications requiring enhanced clarity, the impact modifier preferably has a density of from 0.885 $g/cm^3$ to 0.91 $g/cm^3$. Where clarity is critical, preferably the density of the impact modifier is matched to the density of the high crystalline polypropylene homopolymer or copolymer. In order to be matched, the density of the impact modifier is preferably within 0.03 $g/cm^3$ of the density of the high crystalline polypropylene, more preferably within 0.02 $g/cm^3$, most preferably within 0.01 $g/cm^3$ of the density of the high crystalline polypropylene used.

Degree of crystallinity is measured by differential scanning calorimetry (DSC) using a Q1000 TA Instrument. In this measurement a small ten milligram sample of the propylene polymer is sealed into an aluminum DSC pan. The sample is placed into a DSC cell with a 25 centimeter per minute nitrogen purge and cooled to about minus 100 degrees Celsius. A standard thermal history is established for the sample by heating it at 10 degrees Celsius per minute to 225 degrees Celsius. The sample is kept at 225 degrees Celsius for 3 minutes to ensure complete melting. The sample then is cooled at 10 degrees Celsius per minute to -100 degrees Celsius.

The sample is again kept isothermal at -100 degrees Celsius for 3 minutes to stabilize. It is then reheated at 10 degrees Celsius per minute to 225 degrees Celsius. The observed heat of fusion ($\Delta$H observed) for the second scan over a range of 80-180 degrees Celsius is recorded.

The observed heat of fusion is related to the degree of crystallinity in weight percent based on the weight of the polypropylene sample by the following equation: (2) Crystallinity percent = (H observed) / ($\Delta$H isotactic PP) X100 where the heat of fusion for isotactic polypropylene ($\Delta$H isotacticpp) is reported in B. Wunderlich, Macromolecular Physics, Volume 3, Crystal Melting, Academic Press, New York, 1960, p 48, is 165 Joules per gram(J/g) of polymer.

The peak temperature of crystallization from the melt is determined by the DSC as above with a cooling rate of 10 degrees Celsius/min. The melting temperature is determined by the peak of the melting transition.

Molecular weight distribution (MWD) is determined by gel permeation chromatography (GPC) as follows: The polymers are analyzed by gel permeation chromatography (GPC) on a Polymer Laboratories PL-GPC-220 high temperature chromatographic unit equipped with four linear mixed bed columns, 300 x 7.5 mm (Polymer Laboratories PLgel Mixed A (20-micron particle size). The oven temperature is at 160 degrees Celsius with the autosampler hot zone at 160 degrees Celsius and the warm zone at 145 degrees Celsius. The solvent is 1,2, 4-trichlorobenzene containing 200 ppm 2,6-di-t-butyl-4-methylphenol. The flow rate is 1.0 milliliter/minute and the injection size is 100 microliters. A 0.2 percent by weight solution of the sample is prepared for injection by dissolving the sample in nitrogen purged 1,2, 4-trichlorobenzene containing 200 ppm 2,6-di-t-butyl-4-methylphenol for 2.5 hrs at 160 degrees Celsius with gentle mixing. The molecular weight determination is deduced by using ten narrow molecular weight distribution polystyrene standards (from Polymer Laboratories, EasiCal PS1 ranging from 580 to 7,500,000 g/mole) in conjunction with their elution volumes. The equivalent polypropylene molecular weights are determined by using appropriate Mark-Houwink coefficients for polypropylene (as described by T. G. Scholte, N. L. J. Meijerink, H. M. Schoffeleers, and A. M. G. Brands, J. Appl. Polym. Sci. , 29,3763-3782 (1984), incorporated herein by reference) and polystyrene (as described by E. P. Otocka, R. J. Roe, N. Y.Hellma, P. M. Muglia, Macromolecules, 4,507 (1971) incorporated herein by reference) in the Mark-Houwink equation: {77} = KMa where Kpp=1. 90E-04, app = 0. 725 and Kps=1-26E-04 apS= 0.702.

Melt flow rate is measured in accordance with ASTM D 1238-01 test method at 230 degrees Celsius with a 2.16 kg weight for the propylene-based polymers. Melt index for the ethylene-based polymers is measured in accordance with ASTM D 1238- 01 test method at 190 degrees Celsius with a 2.16 kg weight. Polymer density is measured in accordance with test method ASTM D 792-00.

As a specific example, the container 24 can be a blow molded container made from a blend of 81.51 wt percent high crystalline polypropylene made according to the teachings of WO 2004/033509 A1 having an overall 12 MFR (the high crystalline polypropylene being a blend of 40 wt percent 4 MFR material made according to example 2 of the '509 patent and 60 wt percent 20 MFR material made according to example 3 of the '509 patent) and 17.84 wt percent AFFINITY PL-1880G brand copolymer from The Dow Chemical Company (having a density of 0.902 grams per cubic centimeter), 0.4 wt percent CHIMASORB 944 brand UV stabilizer from Ciba, 0.1 percent IRGANOX 1010 brand antioxidant from Ciba, 0.12 percent Millad 3988 clarifier from Milliken Chemcial Co., and 0.03 wt percent DHT4A brand acid scavenger from Great Lakes Chemical.

As used herein, polypropylene is understood to include any polymer and copolymer of propylene and any polypropylene can be used in the invention. Propylene polymer is typically understood to mean any polymer substantially made up of propylene monomer. Polypropylene copolymer is typically understood to mean any random or block copolymer of propylene substantially made up of propylene monomer and relatively small amounts of other alkenes, for example, about 10 percent or less of ethylene, butene, pentene, hexene and the like as is known in the art. The amount of smaller alkenes is preferably less than about 5 percent.

The open end of tube 16 is then sealed with cover 20 so that a partial vacuum can be pulled on the space defined by tube 16 to create a reduced partial pressure on the inside of container 24. The container 24 is held in place at the neck by a holder 22 for container 24. Partial vacuum is advantageously applied to both the inside and the outside of container 24 to prevent container 24 from being subjected to too large a pressure differential, which could result in deformation of container 24. The partial vacuums of the inside and outside of the container are different, and the partial vacuum maintained on the outside of the container is set so as not to allow plasma formation onto the outside of container 24 where deposition is undesired. Preferably, a partial vacuum in the range of from 10 µbar to 200 µbar is maintained for the inside of container 24 and a partial vacuum of from 10 mbar to 100 mbar, is pulled on the outside of the container 24.

Cover 20 is adapted with an injector 27 that is fitted into container 24 so as to extend at least partially into container 27 to allow introduction of reactive fluid that contains a reactive monomer and a carrier. Injector 27 can be designed to be, for example, porous, open-ended, longitudinally reciprocating, rotating, coaxial, and combinations thereof. As used herein, the word "porous" is used in the traditional sense to mean containing pores, and also broadly refers to all gas transmission pathways, which may include one or more slits. A preferred embodiment of injector 27 is an open-ended porous injector, more preferably an open-ended injector with graded--that is, with different grades or degrees of--porosity, which injector extends preferably to almost the entire length of the container. The pore size of injector 27 preferably increases toward the base of container 24 so as to optimize flux uniformity of activated precursor gases on the inner surface of container 24. FIG. 1 illustrates this difference in porosity by different degrees of shading, which represent that the top third of the injector 27a has a lower porosity than the middle third of the injector 27b, which has a lower porosity than the bottom third of the injector 27c. The porosity of injector 27 generally ranges on the order of 0.5 µm to 1 mm. However, the gradation can take a variety of forms from stepwise, as illustrated, to truly continuous. The cross-sectional diameter of injector 27 can vary from just less than the inner diameter of the narrowest portion of container 24 (generally from 40 mm) to 1 mm.

The apparatus 10 also includes at least one electrically conductive plate in the resonant cavity to tune the geometry of the resonant cavity to control the distribution of plasma in the interior of container 24. More preferably, though not essentially, as illustrated in FIG. 1, the apparatus 10 includes two annular conductive plates 28 and 30, which are located in resonant cavity 12 and encircle tube 16. Plates 28 and 30 are displaced from each other so that they are axially attached on both sides of the tube 16 through which the wave guide 15 empties into resonant cavity 12. Plates 28 and 30 are designed to adjust the electromagnetic field to ignite and sustain plasma during deposition. The position of plates 28 and 30 can be adjusted by sliding rods 32 and 34.

Deposition of polyorganosiloxane and/ or SiOx layers on the container 24 can be accomplished as follows as described in United States Patent Application Publication 2004/0149225 A1. A mixture of gases including a balance gas and a working gas (together, the total gas mixture) is flowed through injector 27 at such a concentration and power density, and for such a time to create coatings with desired properties.

As used herein, the term "working gas" refers to a reactive substance, which may or may not be gaseous at standard temperature and pressure, that is capable of polymerizing to form a coating onto the substrate. Examples of suitable working gases include organosilicon compounds such as silanes, siloxanes, and silazanes. Examples of silanes include tetramethylsilane, trimethylsilane, dimethylsilane, methylsilane, dimethoxydimethylsilane, methyltrimethoxysilane, tetramethoxysilane, methyltriethoxysilane, diethoxydimethylsilane, methyltriethoxysilane, triethoxyvinylsilane, tetraethoxysilane (also known as tetraethylorthosilicate or TEOS), dimethoxymethylphenylsilane, phenyltrimethoxysilane, 3-glycidoxypropyltrimethoxysilane, glycidoxypropyltrimethoxysilane, 3-methacrylpropyltrimethoxysilane, diethoxymethylphenylsilane, tris(2-methoxyethoxy)vinylsilane, phenyltriethoxysilane, and dimethoxydiphenylsilane. Examples of siloxanes include tetramethyldisiloxane, hexamethyldisiloxane, and octamethyltrisiloxane. Examples of silazanes include hexamethyldisilazanes, tetramethyldisilazanes, heptamethyldisilazane and hexamethylcyclotrisilazane. Siloxanes are preferred working gases, with tetramethyldisiloxane (TMDSO) being especially preferred.

As used herein, the term "balance gas" is a reactive or nonreactive gas that carries the working gas through the electrode and ultimately to the substrate. Examples of suitable balance gases include air, $O_2$, $CO_2$, NO, $N_2O$ as well as combinations thereof. Oxygen ($O_2$) is a preferred balance gas.

When a polyorganosiloxane layer is desired in the instant invention, a first organosilicon compound is plasma polymerized in an oxygen rich atmosphere on the inner surface of the container, which may or may not be previously subjected to surface modification, for example, by roughening, crosslinking, or surface oxidation. As used herein, the term "oxygen-rich atmosphere" means that the balance gas contains at least about 20 percent oxygen, more preferably at least about 50 percent oxygen. Thus, for the purposes of this invention, air is a suitable balance gas, but $N_2$ is not.

The quality of the polyorganosiloxane layer is virtually independent of the mole percent ratio of balance gas to the total gas mixture up to about 80 mole percent of the balance gas, at which point the quality of the layer degrades substantially. The power density of the plasma for the preparation of the polyorganosiloxane layer is preferably greater than 10 MJ/kg, more preferably greater than 20 MJ/kg, and most preferably greater than 30 MJ/kg; and preferably less than 1000 MJ/kg, more preferably less than 500 MJ/kg, and most preferably less than 300 MJ/kg.

In this step, the plasma is sustained for preferably less than 5 seconds, more preferably less than 2 seconds, and most preferably less than 1 second; and preferably greater than 0.1 second, and more preferably greater than 0.2 second to form a polyorganosiloxane coating having a thickness of preferably less than 50 nanometer, more preferably less than 20 nanometer, and most preferably less than 10 nanometer; and preferably greater than 2.5 nanometer, more preferably greater than 5 nanometer (nm).

Preferably the polyorganosiloxane coating step is carried out at a deposition rate of less than about 50 nanometer/sec, more preferably less than 20 nanometer/sec, and preferably greater than 5 nanometer/sec, and more preferably greater than 10 nanometer/sec.

The preferred chemical composition of the polyorganosiloxane layer is SiOxCyHz, where x is in the range of 1.0 to 2.4, y is in the range of 0.2 to 2.4, and z is greater than or equal to 0, more preferably not more than 4.

When a silicon oxide layer is desired in the instant invention, an organosilicon compound (which may be the same as or different from the organosilicon compound discussed above) is plasma polymerized to form a silicon oxide layer on the polyorganosiloxane layer described above, or a different polyorganosiloxane layer, or directly on the object. In other words, it is possible, and sometimes advantageous, to have more than one polyorganosiloxane layer of different chemical compositions (or no polyorganosiloxane layer). Preferably, the silicon oxide layer is an SiOx layer, where x is in the range of 1.5 to 2.0.

For the silicon oxide coating step, the mole ratio of balance gas to the total gas mixture is preferably about stoichiometric with respect to the balance gas and the working gas. For example, where the balance gas is oxygen and the working gas is TMDSO, the preferred mole ratio of balance gas to total gas is 85 percent to 95 percent. The power density of the plasma for the preparation of the silicon oxide layer is preferably greater than 10 MJ/kg, more preferably greater than 20 MJ/kg, and most preferably greater than 30 MJ/kg ; and preferably less than 500 MJ/kg, and more preferably less than 300 MJ/kg.

In the silicon oxide coating step, the plasma is sustained for preferably less than 10 seconds, and more preferably less than 5 seconds, and preferably greater than 1 second to form a silicon oxide coating having a thickness of less than 50 nm, more preferably less than 30 nm, and most preferably less than 20 nm, and preferably greater than 5 nm, more preferably greater than 10 nm.

Preferably, the silicon oxide coating step is carried out at a deposition rate of less than about 50 nm/sec, more preferably less than 20 nm/sec, and preferably greater than 5.0 nm/sec, and more preferably greater than 10 nm/sec.

The thickness of the polyorganosiloxane layer, when used, is preferably less than 1000 nm, more preferably less than 100 nm, more preferably less than 40 nm, and most preferably less than 30 nm, and preferably greater than 10 nm. The thickness of the silicon oxide layer, when used, is preferably less than 100 nm, and preferably greater than 10 nm. The total plasma polymerizing deposition time is preferably less than 20 seconds, more preferably less than 10 seconds, and most preferably less than 5 seconds.

Coating adhesion is indicated according to the ASTM D-3359 tape test. The adhesion of a coating on an object is poor when greater than 65 percent of the coating delaminates, which corresponds to a "0" according to such test. The adhesion of a coating on an object is excellent when essentially none of the coating delaminates, which corresponds to a "5" according to such test.

The process of the present invention when used to coat a panel or sheet shaped object is advantageously, though not uniquely, carried out using the electrode discharge plasma coating apparatus and procedure described in US Patents 5,494,712 and 5,433,786 (both of which are fully incorporated herein by reference). When using such a system, the plasma polymerizing step(s) are preferably carried out at a power level of from 100 to 1000 KJ/kg and for a time of less than 1 minute (and more preferably for a time less than 30 second, and yet more preferably less than 5 seconds).

It should be understood that although the above discussion relates to microwave and electrode discharge plasma coating systems, the instant invention is not limited to any specific plasma coating system. Thus, any desired plasma coating system can be used in the instant invention.

The term "molded" used herein includes, without limitation thereto, blow molding (including injection stretched blow molding), roto-molding, thermoforming as well as injection molding.

EXAMPLE 1

A blend of a blend of 81.51 wt percent high crystalline polypropylene made according to the teachings of WO 2004/033509 A1 having an overall 12 MFR (the high crystalline polypropylene being a blend of 40 wt percent 4 MFR material made according to example 2 of the '509 patent and 60 wt percent 20 MFR material made according to example 3 of the '509 patent) and 17.84 wt percent AFFINITY PL-1880G brand copolymer from The Dow Chemical Company (having a density of 0.902 grams per cubic centimeter), 0.4 wt percent CHIMASORB 944 brand UV stabilizer from Ciba, 0.1 percent IRGANOX 1010 brand antioxidant from Ciba, 0.12 percent Millad 3988 clarifier from Milliken Chemcial Co., and 0.03 wt percent DHT4A brand acid scavenger from Great Lakes Chemical is prepared using a 25 mm W&P ZSK twin screw extruder and molded into rectangular plaques using a 100 ton Demag injection molding machine.

Organosiloxane coatings (VPP or SiOxCyHz) are deposited onto the plaques by a capacitively coupled PECVD apparatus similar to that described in the above cited '786 patent. The power supply operates at the frequency of 40 kHz and maximum power of 2KW. Precursor materials are tetramethyldisiloxane (TMDSO) and oxygen. Process parameters include applied power, flow rates of TMDSO and oxygen, deposition time and composite parameter W/FM, which corresponds to the plasma energy per unit mass of precursor mixture. W/FM in units of KJ/kg is calculated for the binary mixture of TMDSO and oxygen by the following formula:

$$\frac{W}{F_{TMDSO}M_{TMDSO} + F_{O2}M_{O2}} \times 1.34 \times 10^{3}$$

whereby W is power, F is flowrate and M is molecular weight. The molecular weight of TMDSO and oxygen are 134 g/mol and 32 g/mol respectively. The following table shows an example of the plasma process parameters for SiOxCyHz deposition.

| Sample | Power | Pressure | TMDSO | O2 | time | W/FM | Thickness |
|---|---|---|---|---|---|---|---|
| (#) | (W) | (mTorr) | (sccm) | (sccm) | (min) | (KJ/kg) | (nm) |
| 5C04083001 | 800 | 5 | 50 | 40 | 10 | 134 | 500 |
| 5C04082001 | 800 | 5 | 50 | 40 | 5 | 134 | 270 |
| 5C04082201 | 800 | 5 | 50 | 40 | 1 | 134 | 50 |

The coated plaques are then subjected to the cross-hatch tape-pull adhesion test (ASTM D-3359). Test results correspond to the percent of coating delaminated (0 = greater than 65 percent; 1 = 35-65 percent; 2 = 15-35 percent; 3 = 5-15 percent, 4 = less than 5 percent; and 5 = essentially 0 percent).

The plaque having a VPP coating thickness of 500nm has a cross-hatch adhesion ranking of 4. The plaque having a VPP coating thickness of 250nm has a cross-hatch adhesion ranking of 4.5. The plaque having a VPP coating thickness of 50nm has a cross-hatch adhesion ranking of 5.

EXAMPLE 2

A blend of 81.51 wt percent high crystalline polypropylene made according to the teachings of WO 2004/033509 A1 having an overall 12 MFR (the high crystalline polypropylene being a blend of 40 wt percent 4 MFR material made according to example 2 of the '509 patent and 60 wt percent 20 MFR material made according to example 3 of the '509 patent) and 17.84 wt percent AFFINITY PL-1880G brand copolymer from The Dow Chemical Company (having a density of 0.902 grams per cubic centimeter), 0.4 wt percent CHIMASORB 944 brand UV stabilizer from Ciba, 0.1 percent IRGANOX 1010 brand antioxidant from Ciba, 0.12 percent Millad 3988 clarifier from Milliken Chemcial Co., and 0.03 wt percent DHT4A brand acid scavenger from Great Lakes Chemical is prepared using a 25 mm W&P ZSK twin screw extruder and molded into rectangular plaques using a 100 ton Demag injection molding machine.

Silicon dioxide (SiOx) coatings are deposited onto the plaques using a capacitively coupled PECVD apparatus similar to that described in the above cited '786 patent. The power supply operates at the frequency of 40 kHz and maximum power of 2KW. Precursor materials are tetramethyldisiloxane (TMDSO) and oxygen. Process parameters include applied power, flow rates of TMDSO and oxygen, deposition time and composite parameter W/FM, which corresponds to the plasma energy per unit mass of precursor mixture. W/FM in units of KJ/kg is calculated for the binary mixture of TMDSO and oxygen by the following formula:

$$\frac{W}{F_{TMDSO}M_{TMDSO} + F_{O2}M_{O2}} \times 1.34 \times 10^3$$

whereby W is power, F is flowrate and M is molecular weight. The molecular weight of TMDSO and oxygen are 134 g/mol and 32 g/mol respectively. The following table shows an example of the plasma process parameters for SiOx deposition on one of the VPP coated plaques:

| Sample | Power | Pressure | TMDSO | O$_2$ | time | W/FM | Thickness |
|---|---|---|---|---|---|---|---|
| (#) | (W) | (mTorr) | (sccm) | (sccm) | (min) | (KJ/kg) | (nm) |
| 5C04082702 | 1584 | 10 | 10 | 200 | 10 | 274 | 65 |
| 5C04082701 | 1584 | 10 | 10 | 200 | 5 | 274 | 31 |
| 5C04090202 | 1584 | 10 | 10 | 200 | 1 | 274 | 9.1 |

The SiOx coated plaques are then subjected to the cross-hatch tape-pull adhesion test (ASTM D-3359). Test results correspond to the percent of coating delaminated (0 = greater than 65 percent; 1 = 35-65 percent; 2 = 15-35 percent; 3 = 5-15 percent, 4 = less than 5 percent; and 5 = essentially 0 percent).

The plaque having a SiOx layer thickness of 65nm has a cross-hatch adhesion ranking of 4.5. The plaque having a SiOx layer thickness of 31nm has a cross-hatch adhesion ranking of 5. The plaque having a SiOx layer thickness of 9nm also has a cross-hatch adhesion ranking of 5.

EXAMPLES 3-6

Four compositions are prepared having an additive package of 0.4 wt percent CHIMASORB 944 brand UV stabilizer from Ciba, 0.1 wt percent IRGONOX 1010 brand antioxidant from Ciba, 0.12 percent Millad 3988 clarifier from Milliken Chemcial Co. and 0.03 wt percent DHT4A brand acid scavenger from Great Lakes Chemical is prepared using a 25 mm W&P ZSK twin screw extruder and molded into rectangular plaques using a 100 ton Demag injection molding machine. The HCPP of Samples 43, 23 and 34 are made according to the teachings of WO 2004/033509 A1 having an overall 12 MFR (being a blend of 40 wt percent 4 MFR material made according to example 2 of the '509 patent and 60 wt percent 20 MFR material made according to example 3 of the '509 patent). The HCPP of Sample 37 is made according to the teachings of WO 2004/033509 A2 example 2 modified to feed hydrogen into the polymerization reactor to reduce the molecular weight of the polymer as evidenced by the MFR of 1.5. The X and Y values of component (ii) of Sample 23 is not stated (but component (ii) of Sample 23 is Dow Affinity PL 1880 brand polymer). The X and Y values of component (ii) of Sample 34 is not stated (but component (ii) of Sample 34 is Exxon Mobil Exact 3128 brand polymer). Component (ii) of Sample 37 is Dupont-Dow Engage ENR7086 brand polymer.

| Sample # | %HCPP/MFR | %Comomomer/MI/Type/Composition/density |
|---|---|---|
| 43 | 81.5/12 | 18/2/EP/15%E, 85%P/0.859 |
| 23 | 81.5/12 | 18/1/EO/83.5%E, 16.5%0/0.902 |
| 34 | 81.5/12 | 18/1.2/EB/X%E, Y%B/0.90 |
| 37 | 81.5/1.5 | 18/0.22/EB/X%E, Y%B/0.902 |

where HCPP is high crystalline polypropylene (HCPP is (i) of the Claims), MFR is melt flow rate, Comonomer is (ii) of the Claims, MI is melt index, E is ethylene, P is propylene, O is octene, B is butene and density is in grams per cubic centimeter.

The plaques are coated as described in Example 1 for 5 and 10 minutes with the following tape adhesion test results.

| Sample # | Coating Time | Tape Adhesion Test Result |
|---|---|---|
| 43 | 5 minutes | 4 |
| 43 | 10 minutes | 2.5 |
| 23 | 5 minutes | 5 |
| 23 | 10 minutes | 4 |
| 34 | 5 minutes | 5 |
| 34 | 10 minutes | 3 |
| 37 | 5 minutes | 4 |
| 37 | 01 minutes | 3 |

EXAMPLE 7

A polymer composition is prepared having an additive package of 0.4 wt percent CHIMASORB 944 brand UV stabilizer from Ciba, 0.1 wt percent IROGONOX 1010 brand antioxidant from Ciba, 0.12 percent Millad 3988 clarifier from Milliken Chemcial Co. and 0.03 wt percent DHT4A brand acid scavenger from Great Lakes Chemical, 79.35 percent high crystalline impact copolymer having an MFR of 12 (consisting of a high crystalline PP homopolymer phase and an in-reactor rubber as detailed at the end of this Example 7) and 20 percent random copolymer (Dow DS6D82 brand polymer) is prepared using a 25 mm W&P ZSK twin screw extruder and molded into rectangular plaques using a 100 ton Demag injection molding machine.

The plaques are coated as described in Example 1 for 5 and 10 minutes with the following tape adhesion test results.

| Coating Time | Tape Adhesion Test Result |
|---|---|
| 5 minutes | 4 |
| 10 minutes | 4 |

The polypropylene impact co-polymer is produced in a reaction system consisting of a bulk phase (condensed propylene) stirred tank pre-polymerization reactor, a bulk phase loop reactor, and a gas phase fluidized bed reactor. A Ziegler - Natta catalyst, which includes a titanium catalytic active metal species on a magnesium chloride support, which is commercially available as Toho Series C, group JC and may be purchased from Toho Titanium Ltd., is suspended in Hydrobrite ® 380 white mineral oil, purchased from Crompton-Witco, at 1.4 wt. percent and stored in a stirred catalyst feed tank. The catalyst is pumped into a 4 liter continuous, stirred tank and mixed for 5 to 20 minutes with an external alkoxysilane donor, commercially available from Degussa, Dicyclopentyldimethoxysilane (Dynaslan ® 9415), and with an aluminum alkyl co-catalyst, triethylaluminum. Both the external donor and the Triethylaluminum are fed as 10 wt. percent solutions in n-hexane. From the 4 liter stirred tank, the catalyst, co-catalyst and external donor flow into a 4 gallon continuous, stirred tank reactor filled with liquid propylene. Desired temperature of the reactor is controlled at 15 °C by controlling the water temperature on the vessel jacket. Propylene is polymerized at low rates for 10 minutes. From the 4 gallon stirred tank reactor, the polymer slurry flows into a 152 gallon jacketed bulk phase loop reactor, filled with liquid propylene. The desired temperature of the loop reactor is controlled at 70°C by controlling the water temperature on the loop jacket. The target concentration for the external donor in the liquid propylene, corrected for solids, is 0.3 mmole/1. The target concentration for the co-catalyst in the liquid propylene, corrected for solids, is 0.8 mmole/1. Propylene polymerization is conducted in the loop reactor with polymer solids at 40 to 45 wt. percent. A chain transfer agent, hydrogen, is continuously fed to the reactor, to produce a 20 g/10min MFR propylene polymer, as measured by ASTM D 1238-01 at 230 degrees Celsius and a 2.16 kg. weight. The reactor discharge stream is degassed in a flash vessel designed to separate the liquid propylene and process lights from the polypropylene powder product. The degassed powder is forwarded to a 14" diameter fluidized bed gas phase reactor. Monomer and co-monomer serve as the reaction medium and as the fluidizing gas. Reactor temperature is controlled at 70°C by controlling the inlet temperature of the incoming fluidizing gas. Ethylene propylene co-polymer that is 50 mole percent ethylene and 50 mole percent propylene is made in the gas phase reactor. Composition is controlled by adjusting the feed rates of ethylene and propylene. The ethylene-propylene co-polymer is controlled to 18 wt. percent of the total polymer produced by adjusting total monomer pressure and gas phase residence time. Co-polymer composition and fraction of the total polymer is determined by mass balance on the gas phase reactor. A chain transfer agent, hydrogen, is continuously fed to the reactor, to produce a 12 g/10min MFR polymer, as measured by ASTM D 1238-01.

The reactor discharge stream is degassed in a flash vessel designed to separate the ethylene and propylene from the polypropylene powder product. The degassed powder is forwarded to a rotating thermal dryer and then to a purge column to remove residual hydrocarbon and to water quench the Triethylaluminum co-catalyst. Purged polymer is transferred to a product hopper and then to boxes.

EXAMPLES 8-11

Four compositions are prepared having an additive package of 0.4 wt percent CHIMASORB 944 brand UV stabilizer from Ciba, 0.1 wt percent IRGONOX 1010 brand antioxidant from Ciba, 0.12 percent Millad 3988 clarifier from Milliken Chemcial Co. and 0.03 wt percent DHT4A brand acid scavenger from Great Lakes Chemical using a 25 mm W&P ZSK twin screw extruder and molded into rectangular plaques using a 100 ton Demag injection molding machine. The HCPP of Samples 39, 40, 41 and 32 are made according to the teachings of WO 2004/033509 A1 having an overall 12 MFR (being a blend of 40 wt percent 4 MFR material made according to example 2 of the '509 patent and 60 wt percent 20 MFR material made according to example 3 of the '509 patent).

| Sample # | %HCPP/MFR %Comomomer/MI/Type/Composition/density |
|---|---|
| 39 | 94.35/12 5/1/EO/83.5%E, 16.5%O/0.902 |
| 40 | 89.35/12 10/1/EO/83.5%E, 16.5%O/0.902 |
| 41 | 84.35/12 15/1/EO/83.5%E, 16.5%O/0.902 |
| 32 | 79.35/12 20/1/EO/83.5%E, 16.5%O/0.902 |

The plaques are coated as described in Example 1 for 5 and 10 minutes with the following tape adhesion test results.

| Sample # | Coating Time | Tape Adhesion Test Result |
|---|---|---|
| 39 | 5 minutes | 4 |
| 39 | 10 minutes | 3 |
| 40 | 5 minutes | 4 |
| 40 | 10 minutes | 3 |
| 41 | 5 minutes | 4 |
| 41 | 10 minutes | 3.5 |
| 32 | 5 minutes | 5 |
| 32 | 10 minutes | 4 |

EXAMPLE 12

A blend of 81.51 wt percent high crystalline polypropylene made according to the teachings of WO 2004/033509 A1 having an overall 12 MFR (the high crystalline polypropylene being a blend of 40 wt percent 4 MFR material made according to example 2 of the '509 patent and 60 wt percent 20 MFR material made according to example 3 of the '509 patent) and 17.84 wt percent AFFINITY PL-1880G brand copolymer from The Dow Chemical Company (having a density of 0.902 grams per cubic centimeter), 0.4 wt percent CHIMASORB 944 brand UV stabilizer from Ciba, 0.1 percent IRGANOX 1010 brand antioxidant from Ciba, 0.12 percent Millad 3988 clarifier from Milliken Chemcial Co., and 0.03 wt percent DHT4A brand acid scavenger from Great Lakes Chemical is prepared using a 25 mm W&P ZSK twin screw extruder and injection stretch blow molded into hot-fillable containers.

Multi-layer coatings composed of an organosiloxane layer (VPP or SiOxCyHz) and a SiOx layer are deposited onto the internal surface of the container by a capacitively coupled PECVD apparatus similar to that described in patent US 6,112,695. The alternating current (AC) power supply operates at an output frequency of 13.56 megahertz (MHz) and maximum power of 750W. Precursor materials are tetramethyldisiloxane (TMDSO) and oxygen. Process parameters include applied power, flow rates of TMDSO and oxygen, and deposition time. The molecular weight of TMDSO and oxygen are 134 g/mol and 32 g/mol respectively. The following table shows an example of the plasma process parameters for SiOxCyHz and SiOx deposition.

| Sample | Coating | Power | Pressure | TMDSO | 02 | time | Thickness |
|---|---|---|---|---|---|---|---|
| (#) | | (W) | (mTorr) | (sccm) | (sccm) | (sec) | (nm) |
| 120204-100 | VPP | 750 | 50 | 5 | 60 | 7 | 24 |
| | $SiO_x$ | 600 | 50 | 2 | 75 | 7 | 30 |

The internal surface of coated containers is then subjected to the tape-pull adhesion test (ASTM D-3359). Test results correspond to the percent of coating delaminated (0 = greater that 65 percent; 1 = 35-65 percent; 2 = 15-35 percent; 3 = 5-15 percent, 4 = less than 5 percent; and 5 = essentially 0 percent). The container having a VPP/SiOx internal coating has a cross-hatch adhesion ranking of 5 before and after hot-filling the container.

Hot-filling is carried out by filling the container with 85°C water, allowing to stand for 1 minute before capping, allowing to stand 1 additional minute before immersing in an ice bath for an additional 5 minutes, and finally allowing the container to equilibrate in air to room temperature.

The oxygen transmission rate (OTR) was measured by MOCON in a controlled temperature and relative humidity room of 23°C and 40 percent RH, respectively. An uncoated container was measured with an OTR of 0.87 cc/bottle/day before hot-fill and 0.80 cc/bottle/day after hot-fill. A VPP/SiOx coated container was measured with an OTR of 0.047 cc/bottle/day before hot-fill and 0.078 cc/bottle/day after hot-fill. For comparison, a similar uncoated hot-fill container composed of PET resin was measured with an OTR of 0.051 cc/bottle/day.

## CONCLUSION

While this invention has been described as having preferred aspects, the instant invention can be further modified within the spirit and scope of this disclosure. This application is therefore intended to cover any variations, uses, or adaptations of the present invention using the general principles disclosed herein. Further, this application is intended to cover such departures from the present disclosure as come within the known or customary practice in the art to which this invention pertains and which fall within the limits of the appended claims.

**Claims**

1.  A process for preparing a coating on an object, the coating having a cross-hatch adhesion ranking of better than 3 according to the ASTM D-3359 test, comprising the steps of: (a) plasma polymerizing an organosilicon compound under conditions to deposit a polyorganosiloxane layer onto the object, the polyorganosiloxane layer being thicker than 5nm; and/or (b) plasma polymerizing a organosilicon compound under conditions to deposit a silicon oxide layer directly on the object or onto a polyorganosiloxane layer prepared according to step (a), the silicon oxide layer being thicker than 5nm wherein the object comprises a polymer composition comprising (i) from 99 to 50 weight percent of a polymer having more than 90 weight percent monomer units containing three carbons and optionally monomer units selected from the group consisting of alpha olefins containing two carbons and/or from four to twelve carbons, and (ii) from 1 to 50 weight percent of a second copolymer comprising monomer units selected from the group consisting of alpha olefins containing two carbons and alpha olefins containing from four to twelve carbons and optionally up to 10 weight percent of a diene monomer containing less than thirteen carbons; or the object comprises an alternative polymer composition comprising (iii) from 1 to 50 weight percent of a copolymer of propylene and up to 10 weight percent of a comonomer selected from the group consisting of alpha olefins containing two carbons and/or from four to twelve carbons, and (iv) from 99 to 50 weight percent of an impact copolymer consisting of a blend of homopolymer polypropylene with up to 50 weight percent of a random copolymer of propylene and an alpha olefin containing two carbons and/or from four to twelve carbons.

2. The process of any of Claims 1, wherein the polyorganosiloxane layer is present and comprises SiOxCyHz, where x is in the range of 1.0 to 2.4, y is in the range of 0.2 to 2.4, and z is in the range of 0 to 4.

3. The process of any of Claims 1-2, wherein the silicon oxide layer is present and comprises SiOx, where x is in the range of 1.5 to 2.4.

4. The process of any of Claims 1-3, wherein the cross-hatch adhesion ranking is better than 4.

5. The process of any of Claims 1-3, wherein the cross-hatch adhesion ranking is essentially 5.

6. The process of any of Claims 1-5, wherein the density of component (ii), if present, is between 0.85 and 0.93 grams per cubic centimeter.

7. The process of any of Claims 1-5, wherein the density of component (ii), if present, is between 0.854 and 0.92 grams per cubic centimeter.

8. The process of any of Claims 1-5, wherein the density of component (ii), if present, is between 0.86 and 0.91 grams per cubic centimeter.

9. The process of any of Claims 1-8, wherein the melt index of component (ii), if present, is between 0.1 and 500 as determined by ASTM method D 1238-01 at 190 degrees Celsius with a 2.16 Kg. weight.

10. The process of any of Claims 1-8, wherein the melt index of component (ii), if present, is between 0.2 and 100 as determined by ASTM method D 1238-01 at 190 degrees Celsius with a 2.16 Kg. weight.

11. The process of any of Claims 1-8, wherein the melt index of component (ii), if present, is between 0.3 and 50 as determined by ASTM method D 1238-01 at 190 degrees Celsius with a 2.16 Kg. weight.

12. The process of any of Claims 1-11, wherein the melt flow rate of the polymer composition is between 0.1 and 500 grams per ten minutes as determined by ASTM method D 1238-01 at 230 degrees Celsius with a 2.16 Kg. weight.

13. The process of any of Claims 1-11, wherein the melt flow rate of the polymer composition is between 0.2 and 150 grams per ten minutes as determined by ASTM method D 1238-01 at 230 degrees Celsius with a 2.16 Kg. weight.

14. The process of any of Claims 1-11, wherein the melt flow rate of the polymer composition is between 0.3 and 100 grams per ten minutes as determined by ASTM method D 1238-01 at 230 degrees Celsius with a 2.16 Kg. weight.

15. The process of any of Claims 1-14, wherein the polyorganosiloxane layer is present and has a thickness less than 1000nm and the silicon oxide layer is also present and has a thickness less than 100nm.

16. An article of manufacture, comprising: a body comprising a polymer composition comprising (i) from 99 to 50 weight percent of a polymer having more than 90 weight percent monomer units containing three carbons and optionally monomer units selected from the group consisting of alpha olefins containing two carbons and/or from four to twelve carbons, and (ii) from 1 to 50 weight percent of a second copolymer comprising monomer units selected from the group consisting of alpha olefins containing two carbons and alpha olefins containing from four to twelve carbons and optionally up to 10 weight percent of a diene monomer containing less than thirteen carbons; or the body comprising an alternative polymer composition comprising (iii) from 1 to 50 weight percent of a copolymer of propylene and up to 10 weight percent of a comonomer selected from the group consisting of alpha olefins containing two carbons and/or from four to twelve carbons, and (iv) from 99 to 50 weight percent of an impact copolymer consisting of a blend of homopolymer polypropylene with up to 50 weight percent of a random copolymer of propylene and an alpha olefin containing two carbons and/or from four to twelve carbons; the article further comprising a coating on the body wherein the coating comprises a polyorganosiloxane layer thicker than 5nm, or a silicon oxide layer thicker than 10nm, or a silicon oxide layer thicker than 10nm superposing a polyorganosiloxane layer thicker than 5nm, wherein the article has a cross-hatch adhesion ranking according to the ASTM D-3359 test of the polyorganosiloxane layer, the silicon oxide layer or both on the body of greater than 3.

17. The article of manufacture of Claim 16, wherein the cross-hatch adhesion ranking is greater than 4.

18. The article of manufacture of Claim 16, wherein the cross-hatch adhesion ranking is essentially 5.

19. The article of manufacture of any of Claims 16-18, wherein the polyorganosiloxane layer is present and comprises SiOxCyHz, where x is in the range of 1.0 to 2.4, y is in the range of 0.2 to 2.4, and z is in the range of 0 to 4.

20. The article of manufacture of any of Claims 16-19, wherein the silicon oxide layer is present and comprises SiOx, where x is in the range of 1.5 to 2.0.

21. The article of manufacture of any of Claims 16-20, wherein the body is extruded.

22. The article of manufacture of any of Claims 16-20, wherein the body is molded.

23. The article of manufacture of Claim 22, wherein the body is a molded container.

24. The article of manufacture of Claim 23, wherein the molded container is a molded bottle.

25. The article of manufacture of any of Claims 16-24, wherein the polyorganosiloxane layer is present and has a thickness of less than 1000nm and the silicon oxide layer is also present and has a thickness less than 100nm.

26. The article of any of Claims 16-25, wherein the density of component (ii), if present, is between 0.854 and 0.92 grams per cubic centimeter.

27. The article of any of Claims 16-25, wherein the density of component (ii), if present, is between 0.86 and 0.91 grams per cubic centimeter.

28. The article of any of Claims 16-25, wherein the melt index of component (ii), if present, is between 0.1 and 500 as determined by ASTM method D 1238-01 at 190 degrees Celsius with a 2.16 Kg. weight.

29. The article of any of Claims 16-25, wherein the melt index of component (ii), if present, is between 0.2 and 100 as determined by ASTM method D 1238-01 at 190 degrees Celsius with a 2.16 Kg. weight.

30. The article of any of Claims 16-25, wherein the melt index of component (ii), if present, is between 0.3 and 50 as determined by ASTM method D 1238-01 at 190 degrees Celsius with a 2.16 Kg. weight.

31. The article of any of Claims 16-30, wherein the melt flow rate of the polymer composition is between 0.1 and 500 grams per ten minutes as determined by ASTM method D 1238-01 at 230 degrees Celsius with a 2.16 Kg. weight.

32. The article of any of Claims 16-30, wherein the melt flow rate of the polymer composition is between 0.2 and 150 grams per ten minutes as determined by ASTM method D 1238-01 at 230 degrees Celsius with a 2.16 Kg. weight.

33. The article of any of Claims 16-30, wherein the melt flow rate of the polymer composition is between 0.3 and 100 grams per ten minutes as determined by ASTM method D 1238-01 at 230 degrees Celsius with a 2.16 Kg. weight.

34. The article of any of Claims 21-24, wherein the oxygen transmission rate across the container or bottle as determined by MOCON measurement at 23 degrees Celsius and 40 percent relative humidity is reduced by a factor greater than five fold in comparison to an uncoated container.

35. The article of any of Claims 21-24, wherein the oxygen transmission rate across the container or bottle as determined by MOCON measurement at 23 degrees Celsius and 40 percent relative humidity after filling the container with a hot liquid at 85 degrees Celsius followed by cooling to room temperature is reduced by a factor greater than two fold in comparison to an uncoated container filled with hot liquid at 85 degrees Celsius followed by cooling to room temperature.

36. The article of Claim 34 wherein the oxygen transmission rate across the container or bottle as determined by MOCON measurement at 23 degrees Celsius and 40 percent relative humidity is reduced by a factor greater than eighteen fold in comparison to an uncoated container.

37. The article of Claim 35 wherein the oxygen transmission rate across the container or bottle as determined by MOCON measurement at 23 degrees Celsius and 40 percent relative humidity after filling the container with a hot liquid at 85 degrees Celsius followed by cooling to room temperature is reduced by a factor greater than ten fold in comparison to an uncoated container filled with hot liquid at 85 degrees Celsius followed by cooling to room temperature.

## Patentansprüche

1. Verfahren zum Herstellen einer Beschichtung auf einem Gegenstand, wobei die Beschichtung beim Gitterschnitt-Test gemäß ASTM D-3359 ein Ergebnis besser als 3 hat, mit den folgenden Schritten: (a) Plasmapolymerisieren einer siliciumorganischen Verbindung unter Bedingungen zum Abscheiden einer Polyorganosiloxanschicht auf dem Gegenstand, wobei die Polyorganosiloxanschicht dicker ist als 5 nm; und/oder (b) Plasmapolymerisieren einer siliciumorganischen Verbindung unter Bedingungen zum Abscheiden einer Siliciumoxidschicht direkt auf dem Gegenstand oder auf einer gemäß Schritt (a) hergestellten Polyorganosiloxanschicht, wobei die Siliciumoxidschicht dicker ist als 5 nm, wobei der Gegenstand eine Polymerzusammensetzung umfasst, die (i) von 99 bis 50 Gew.-% eines Polymers mit mehr als 90 Gew.-% Monomereinheiten umfasst, die drei Kohlenstoffe enthalten, und optional Monomereinheiten, die aus der aus $\alpha$-Olefinen mit zwei Kohlenstoffen und/oder mit vier bis zwölf Kohlenstoffen bestehenden Gruppe ausgewählt sind, und (ii) von 1 bis 50 Gew.-% eines zweiten Copolymers mit Monomereinheiten, die aus der aus $\alpha$-Olefinen mit zwei Kohlenstoffen und $\alpha$-Olefinen mit vier bis zwölf Kohlenstoffen bestehenden Gruppe ausgewählt sind, und optional bis zu 10 Gew.-% eines Dienmonomers mit weniger als 13 Kohlenstoffen; oder der Gegenstand umfasst eine alternative Polymerzusammensetzung, die (iii) von 1 bis 50 Gew.-% eines Copolymers von Propylen und bis zu 10 Gew.-% eines Comonomers umfasst, das aus der aus $\alpha$-Olefinen mit zwei Kohlenstoffen und/oder von vier bis zwölf Kohlenstoffen bestehenden Gruppe ausgewählt ist, und (iv) von 99 bis 50 Gew.-% eines schlagzähen Copolymers, das aus einer Mischung von homopolymerem Polypropylen mit bis zu 50 Gew.-% eines statistischen Copolymers von Propylen und einem $\alpha$-Olefin mit zwei Kohlenstoffen und/oder mit vier bis zwölf Kohlenstoffen besteht.

2. Verfahren nach Anspruch 1, wobei die Polyorganosiloxanschicht vorhanden ist und $SiO_xC_yH_z$ umfasst, wo x im Bereich von 1,0 bis 2,4 liegt, y im Bereich von 0,2 bis 2,4 liegt und z im Bereich von 0 bis 4 liegt.

3. Verfahren nach einem der Ansprüche 1-2, wobei die Siliciumoxidschicht vorhanden ist und $SiO_x$ umfasst, wo x im Bereich von 1,5 bis 2,4 liegt.

4. Verfahren nach einem der Ansprüche 1-3, wobei das Ergebnis im Gitterschnitt-Test besser ist als 4.

5. Verfahren nach einem der Ansprüche 1-3, wobei das Ergebnis im Gitterschnitt-Test im Wesentlichen 5 ist.

6. Verfahren nach einem der Ansprüche 1-5, wobei die Dichte von Komponente (ii), falls vorhanden, zwischen 0,85 und 0,93 Gramm pro Kubikzentimeter liegt.

7. Verfahren nach einem der Ansprüche 1-5, wobei die Dichte von Komponente (ii), falls vorhanden, zwischen 0,854 und 0,92 Gramm pro Kubikzentimeter liegt.

8. Verfahren nach einem der Ansprüche 1-5, wobei die Dichte von Komponente (ii), falls vorhanden, zwischen 0,86 und 0,91 Gramm pro Kubikzentimeter liegt.

9. Verfahren nach einem der Ansprüche 1-8, wobei der Schmelzindex von Komponente (ii), falls vorhanden, zwischen 0,1 und 500 liegt, ermittelt nach dem ASTM-Verfahren D 1238-01 bei 190°C mit einem Gewicht von 2,16 kg.

10. Verfahren nach einem der Ansprüche 1-8, wobei der Schmelzindex von Komponente (ii), falls vorhanden, zwischen 0,2 und 100 liegt, ermittelt nach dem ASTM-Verfahren D 1238-01 bei 190°C mit einem Gewicht von 2,16 kg.

11. Verfahren nach einem der Ansprüche 1-8, wobei der Schmelzindex von Komponente (ii), falls vorhanden, zwischen 0,3 und 50 liegt, ermittelt nach dem ASTM-Verfahren D 1238-01 bei 190°C mit einem Gewicht von 2,16 kg.

12. Verfahren nach einem der Ansprüche 1-11, wobei die Schmelzflussrate der Polymerzusammensetzung zwischen 0,1 und 500 Gramm pro zehn Minuten liegt, ermittelt nach dem ASTM-Verfahren D 1238-01 bei 230°C mit einem Gewicht von 2,16 kg.

13. Verfahren nach einem der Ansprüche 1-11, wobei die Schmelzflussrate der Polymerzusammensetzung zwischen 0,2 und 150 Gramm pro zehn Minuten liegt, ermittelt nach dem ASTM-Verfahren D 1238-01 bei 230°C mit einem Gewicht von 2,16 kg.

14. Verfahren nach einem der Ansprüche 1-11, wobei die Schmelzflussrate der Polymerzusammensetzung zwischen 0,3 und 100 Gramm pro zehn Minuten liegt, ermittelt nach dem ASTM-Verfahren D 1238-01 bei 230°C mit einem Gewicht von 2,16 kg.

15. Verfahren nach einem der Ansprüche 1-14, wobei die Polyorganosiloxanschicht vorhanden ist und eine Dicke kleiner als 1000 nm hat und die Siliciumoxidschicht ebenfalls vorhanden ist und eine Dicke kleiner als 100 nm hat.

16. Fertigungsgegenstand, der Folgendes umfasst: einen Körper aus einer Polymerzusammensetzung, die (i) von 99 bis 50 Gew.-% eines Polymers mit mehr als 90 Gew.-% Monomereinheiten umfasst, die drei Kohlenstoffe enthalten, und optional Monomereinheiten, die aus der aus $\alpha$-Olefinen mit zwei Kohlenstoffen und/oder mit vier bis zwölf Kohlenstoffen bestehenden Gruppe ausgewählt sind, und (ii) von 1 bis 50 Gew.-% eines zweiten Copolymers mit Monomereinheiten, die aus der aus $\alpha$-Olefinen mit zwei Kohlenstoffen und $\alpha$-Olefinen mit vier bis zwölf Kohlenstoffen bestehenden Gruppe ausgewählt sind, und optional bis zu 10 Gew.-% eines Dienmonomers mit weniger als 13 Kohlenstoffen; oder der Körper umfasst eine alternative Polymerzusammensetzung, die (iii) von 1 bis 50 Gew.-% eines Copolymers von Propylen und bis zu 10 Gew.-% eines Comonomers umfasst, das aus der aus $\alpha$-Olefinen mit zwei Kohlenstoffen und/oder mit vier bis zwölf Kohlenstoffen bestehenden Gruppe ausgewählt ist, und (iv) von 99 bis 50 Gew.-% eines schlagzähen Copolymers, das aus einer Mischung von homopolymerem Polypropylen mit bis zu 50 Gew.-% eines statistischen Copolymers von Propylen und einem $\alpha$-Olefin mit zwei Kohlenstoffen und/oder mit vier bis zwölf Kohlenstoffen besteht; wobei der Gegenstand ferner eine Beschichtung auf dem Körper umfasst, wobei die Beschichtung eine Polyorganosiloxanschicht dicker als 5 nm oder eine Siliciumoxidschicht dicker als 10 nm umfasst, oder eine Siliciumoxidschicht dicker als 10 nm über einer Polyorganosiloxanschicht dicker als 5 nm, wobei der Gegenstand im Gitterschnitt-Test gemäß ASTM D-3359 der Polyorganosiloxanschicht, der Siliciumoxidschicht oder von beiden auf dem Körper ein Ergebnis größer als 3 hat.

17. Fertigungsgegenstand nach Anspruch 16, wobei das Ergebnis im Gitterschnitt-Test größer ist als 4.

18. Fertigungsgegenstand nach Anspruch 16, wobei das Ergebnis im Gitterschnitt-Test im Wesentlichen 5 ist.

19. Fertigungsgegenstand nach einem der Ansprüche 16-18, wobei die Polyorganosiloxanschicht vorhanden ist und $SiO_xC_yH_z$ umfasst, wo x im Bereich von 1,0 bis 2,4 liegt, y im Bereich von 0,2 bis 2,4 liegt und z im Bereich von 0 bis 4 liegt.

20. Fertigungsgegenstand nach einem der Ansprüche 16-19, wobei die Siliciumoxidschicht vorhanden ist und $SiO_x$ umfasst, wo x im Bereich von 1,5 bis 2,0 liegt.

21. Fertigungsgegenstand nach einem der Ansprüche 16-20, wobei der Körper extrudiert ist.

22. Fertigungsgegenstand nach einem der Ansprüche 16-20, wobei der Körper geformt ist.

23. Fertigungsgegenstand nach Anspruch 22, wobei der Körper ein geformter Behälter ist.

24. Fertigungsgegenstand nach Anspruch 23, wobei der geformte Behälter eine geformte Flasche ist.

25. Fertigungsgegenstand nach einem der Ansprüche 16-24, wobei die Polyorganosiloxanschicht vorhanden ist und eine Dicke kleiner als 1000 nm hat und die Siliciumoxidschicht ebenfalls vorhanden ist und eine Dicke kleiner als 100 nm hat.

26. Gegenstand nach einem der Ansprüche 16-25, wobei die Dichte von Komponente (ii), falls vorhanden, zwischen 0,854 und 0,92 Gramm pro Kubikzentimeter liegt.

**27.** Gegenstand nach einem der Ansprüche 16-25, wobei die Dichte von Komponente (ii), falls vorhanden, zwischen 0,86 und 0,91 Gramm pro Kubikzentimeter liegt.

**28.** Gegenstand nach einem der Ansprüche 16-25, wobei der Schmelzindex von Komponente (ii), falls vorhanden, zwischen 0,1 und 500 liegt, ermittelt nach dem ASTM-Verfahren D 1238-01 bei 190°C mit einem Gewicht von 2,16 kg.

**29.** Gegenstand nach einem der Ansprüche 16-25, wobei der Schmelzindex von Komponente (ii), falls vorhanden, zwischen 0,2 und 100 liegt, ermittelt nach dem ASTM-Verfahren D 1238-01 bei 190°C mit einem Gewicht von 2,16 kg.

**30.** Gegenstand nach einem der Ansprüche 16-25, wobei der Schmelzindex von Komponente (ii), falls vorhanden, zwischen 0,3 und 50 liegt, ermittelt nach dem ASTM-Verfahren D 1238-01 bei 190°C mit einem Gewicht von 2,16 kg.

**31.** Gegenstand nach einem der Ansprüche 16-30, wobei die Schmelzflussrate der Polymerzusammensetzung zwischen 0,1 und 500 Gramm pro zehn Minuten liegt, ermittelt nach dem ASTM-Verfahren D 1238-01 bei 230°C mit einem Gewicht von 2,16 kg.

**32.** Gegenstand nach einem der Ansprüche 16-30, wobei die Schmelzflussrate der Polymerzusammensetzung zwischen 0,2 und 150 Gramm pro zehn Minuten liegt, ermittelt nach dem ASTM-Verfahren D 1238-01 bei 230°C mit einem Gewicht von 2,16 kg.

**33.** Gegenstand nach einem der Ansprüche 16-30, wobei die Schmelzflussrate der Polymerzusammensetzung zwischen 0,3 und 100 Gramm pro zehn Minuten liegt, ermittelt nach dem ASTM-Verfahren D 1238-01 bei 230°C mit einem Gewicht von 2,16 kg.

**34.** Gegenstand nach einem der Ansprüche 21-24, wobei die Sauerstoffdurchlässigkeit über den Behälter oder die Flasche, ermittelt durch eine MOCON-Messung bei 23°C und 40% relativer Feuchte, um einen Faktor größer als das 5-Fache gegenüber einem unbeschichteten Behälter verringert ist.

**35.** Gegenstand nach einem der Ansprüche 21-24, wobei die Sauerstoffdurchlässigkeit über den Behälter oder die Flasche, ermittelt durch eine MOCON-Messung bei 23°C und 40% relativer Feuchte, nach dem Füllen des Behälters mit einer heißen Flüssigkeit bei 85°C und anschließendem Abkühlen auf Raumtemperatur um einen Faktor größer als das 2-Fache gegenüber einem unbeschichteten Behälter verringert ist, der mit einer heißen Flüssigkeit bei 85°C gefüllt ist und anschließend auf Raumtemperatur abgekühlt wird.

**36.** Gegenstand nach Anspruch 34, wobei die Sauerstoffdurchlässigkeit über den Behälter oder die Flasche, ermittelt durch eine MOCON-Messung bei 23°C und 40% relativer Feuchte, um einen Faktor größer als das 18-Fache gegenüber einem unbeschichteten Behälter verringert ist.

**37.** Gegenstand nach Anspruch 35, wobei wobei die Sauerstoffdurchlässigkeit über den Behälter oder die Flasche, ermittelt durch eine MOCON-Messung bei 23°C und 40% relativer Feuchte, nach dem Füllen des Behälters mit einer heißen Flüssigkeit bei 85°C und anschließendem Abkühlen auf Raumtemperatur um einen Faktor größer als das 10-Fache gegenüber einem unbeschichteten Behälter verringert ist, der mit einer heißen Flüssigkeit bei 85°C gefüllt ist und anschließend auf Raumtemperatur abgekühlt wird.

**Revendications**

**1.** Procédé de préparation, sur un objet, d'un revêtement qui présente, pour un échantillon hachuré en carrés, une note d'adhérence meilleure que 3, selon l'essai ASTM D-3359, lequel procédé comporte les étapes suivantes :

a) faire polymériser un composé de type organo-silicium avec activation par plasma, dans des conditions qui font qu'une couche de polyorganosiloxane se dépose sur l'objet, laquelle couche de polyorganosiloxane est épaisse de plus de 5 nm ;
b) et/ou faire polymériser un composé de type organo-silicium avec activation par plasma, dans des conditions qui font qu'une couche d'oxyde de silicium se dépose directement sur l'objet, ou sur une couche de polyorganosiloxane préparée selon l'étape (a), laquelle couche d'oxyde de silicium est épaisse de plus de 5 nm ;

et dans lequel procédé ledit objet comprend une composition de polymères comprenant :

i) de 99 à 50 % en poids d'un polymère qui contient plus de 90 % en poids de motifs dérivés d'un monomère comportant 3 atomes de carbone, et en option, des motifs dérivés d'un ou de monomère(s) choisi(s) dans l'ensemble formé par les alpha-oléfines comportant 2 et/ou de 4 à 12 atomes de carbone,

ii) et de 1 à 50 % en poids d'un deuxième copolymère qui contient des motifs dérivés de monomères choisis dans l'ensemble formé par les alpha-oléfines comportant 2 atomes de carbone et les alpha-oléfines comportant de 4 à 12 atomes de carbone, ainsi que, en option, de jusqu'à 10 % en poids d'un monomère de type diène comportant moins de treize atomes de carbone ;

ou bien ledit objet comprend une autre composition de polymères comprenant :

iii) de 1 à 50 % en poids d'un copolymère de propylène et de jusqu'à 10 % en poids d'un comonomère choisi dans l'ensemble formé par les alpha-oléfines comportant 2 et/ou de 4 à 12 atomes de carbone,

iv) et de 99 à 50 % en poids d'un copolymère de qualité choc, qui consiste en un mélange d'un polypropylène homopolymère et de jusqu'à 50 % en poids d'un copolymère statistique de propylène et d'une alpha-oléfine comportant 2 et/ou de 4 à 12 atomes de carbone.

2. Procédé conforme à la revendication 1, dans lequel la couche de polyorganosiloxane est présente et comprend un matériau de formule $SiO_xC_yH_z$ où l'indice x vaut de 1,0 à 2,4, l'indice y vaut de 0,2 à 2,4, et l'indice z vaut de 0 à 4.

3. Procédé conforme à la revendication 1 ou 2, dans lequel la couche d'oxyde de silicium est présente et comprend un matériau de formule $SiO_x$ où l'indice x vaut de 1,5 à 2,4.

4. Procédé conforme à l'une des revendications 1 à 3, dans lequel la note d'adhérence pour un échantillon hachuré en carrés est meilleure que 4.

5. Procédé conforme à l'une des revendications 1 à 3, dans lequel la note d'adhérence pour un échantillon hachuré en carrés vaut pratiquement 5.

6. Procédé conforme à l'une des revendications 1 à 5, dans lequel la masse volumique du composant (ii), s'il est présent, vaut entre 0,85 et 0,93 gramme par centimètre cube.

7. Procédé conforme à l'une des revendications 1 à 5, dans lequel la masse volumique du composant (ii), s'il est présent, vaut entre 0,854 et 0,92 gramme par centimètre cube.

8. Procédé conforme à l'une des revendications 1 à 5, dans lequel la masse volumique du composant (ii), s'il est présent, vaut entre 0,86 et 0,91 gramme par centimètre cube.

9. Procédé conforme à l'une des revendications 1 à 8, dans lequel l'indice de fluidité à chaud du composant (ii), s'il est présent, mesuré selon le procédé ASTM D-1238-01 à 190 °C sous une charge de 2,16 kg, vaut entre 0,1 et 500.

10. Procédé conforme à l'une des revendications 1 à 8, dans lequel l'indice de fluidité à chaud du composant (ii), s'il est présent, mesuré selon le procédé ASTM D-1238-01 à 190 °C sous une charge de 2,16 kg, vaut entre 0,2 et 100.

11. Procédé conforme à l'une des revendications 1 à 8, dans lequel l'indice de fluidité à chaud du composant (ii), s'il est présent, mesuré selon le procédé ASTM D-1238-01 à 190 °C sous une charge de 2,16 kg, vaut entre 0,3 et 50.

12. Procédé conforme à l'une des revendications 1 à 11, dans lequel l'indice de fluidité à chaud de la composition de polymères, mesuré selon le procédé ASTM D-1238-01 à 230 °C sous une charge de 2,16 kg, vaut entre 0,1 et 500 grammes par 10 minutes.

13. Procédé conforme à l'une des revendications 1 à 11, dans lequel l'indice de fluidité à chaud de la composition de polymères, mesuré selon le procédé ASTM D-1238-01 à 230 °C sous une charge de 2,16 kg, vaut entre 0,2 et 150 grammes par 10 minutes.

14. Procédé conforme à l'une des revendications 1 à 11, dans lequel l'indice de fluidité à chaud de la composition de polymères, mesuré selon le procédé ASTM D-1238-01 à 230 °C sous une charge de 2,16 kg, vaut entre 0,3 et 100 grammes par 10 minutes.

**15.** Procédé conforme à l'une des revendications 1 à 14, dans lequel la couche de polyorganosiloxane est présente, avec une épaisseur inférieure à 1000 nm, et la couche d'oxyde de silicium est elle aussi présente, avec une épaisseur inférieure à 100 nm.

**16.** Article manufacturé, comprenant un corps qui comprend une composition de polymères comprenant :

i) de 99 à 50 % en poids d'un polymère qui contient plus de 90 % en poids de motifs dérivés d'un monomère comportant 3 atomes de carbone, et en option, des motifs dérivés d'un ou de monomère(s) choisi(s) dans l'ensemble formé par les alpha-oléfines comportant 2 et/ou de 4 à 12 atomes de carbone,
ii) et de 1 à 50 % en poids d'un deuxième copolymère qui contient des motifs dérivés de monomères choisis dans l'ensemble formé par les alpha-oléfines comportant 2 atomes de carbone et les alpha-oléfines comportant de 4 à 12 atomes de carbone, ainsi que, en option, de jusqu'à 10 % en poids d'un monomère de type diène comportant moins de treize atomes de carbone ;

ou un corps qui comprend une autre composition de polymères comprenant :

iii) de 1 à 50 % en poids d'un copolymère de propylène et de jusqu'à 10 % en poids d'un comonomère choisi dans l'ensemble formé par les alpha-oléfines comportant 2 et/ou de 4 à 12 atomes de carbone,
iv) et de 99 à 50 % en poids d'un copolymère de qualité choc, qui consiste en un mélange d'un polypropylène homopolymère et de jusqu'à 50 % en poids d'un copolymère statistique de propylène et d'une alpha-oléfine comportant 2 et/ou de 4 à 12 atomes de carbone ;

lequel article comprend en outre un revêtement disposé sur le corps, lequel revêtement comprend soit une couche de polyorganosiloxane épaisse de plus de 5 nm, soit une couche d'oxyde de silicium épaisse de plus de 10 nm, soit une couche d'oxyde de silicium épaisse de plus de 10 nm et superposée à une couche de polyorganosiloxane épaisse de plus de 5 nm, et pour lequel article la note d'adhérence, pour un échantillon hachuré en carrés, selon l'essai ASTM D-3359, que ce soit avec la couche de polyorganosiloxane, la couche d'oxyde de silicium ou ces deux couches sur le corps, est meilleure que 3.

**17.** Article manufacturé, conforme à la revendication 16, pour lequel la note d'adhérence, pour un échantillon hachuré en carrés, est meilleure que 4.

**18.** Article manufacturé, conforme à la revendication 16, pour lequel la note d'adhérence, pour un échantillon hachuré en carrés, vaut pratiquement 5.

**19.** Article manufacturé, conforme à l'une des revendications 16 à 18, dans lequel la couche de polyorganosiloxane est présente et comprend un matériau de formule SiOxCyHz où l'indice x vaut de 1,0 à 2,4, l'indice y vaut de 0,2 à 2,4, et l'indice z vaut de 0 à 4.

**20.** Article manufacturé, conforme à l'une des revendications 16 à 19, dans lequel la couche d'oxyde de silicium est présente et comprend un matériau de formule SiOx où l'indice x vaut de 1,5 à 2,0.

**21.** Article manufacturé, conforme à l'une des revendications 16 à 20, dans lequel le corps est un corps extrudé.

**22.** Article manufacturé, conforme à l'une des revendications 16 à 20, dans lequel le corps est un corps moulé.

**23.** Article manufacturé, conforme à la revendication 22, dans lequel le corps est un récipient moulé.

**24.** Article manufacturé, conforme à la revendication 23, dans lequel le récipient moulé est une bouteille moulée.

**25.** Article manufacturé, conforme à l'une des revendications 16 à 24, dans lequel la couche de polyorganosiloxane est présente, avec une épaisseur inférieure à 1000 nm, et la couche d'oxyde de silicium est elle aussi présente, avec une épaisseur inférieure à 100 nm.

**26.** Article conforme à l'une des revendications 16 à 25, dans lequel la masse volumique du composant (ii), s'il est présent, vaut entre 0,854 et 0,92 gramme par centimètre cube.

**27.** Article conforme à l'une des revendications 16 à 25, dans lequel la masse volumique du composant (ii), s'il est présent, vaut entre 0,86 et 0,91 gramme par centimètre cube.

28. Article conforme à l'une des revendications 16 à 25, dans lequel l'indice de fluidité à chaud du composant (ii), s'il est présent, mesuré selon le procédé ASTM D-1238-01 à 190 °C sous une charge de 2,16 kg, vaut entre 0,1 et 500.

29. Article conforme à l'une des revendications 16 à 25, dans lequel l'indice de fluidité à chaud du composant (ii), s'il est présent, mesuré selon le procédé ASTM D-1238-01 à 190 °C sous une charge de 2,16 kg, vaut entre 0,2 et 100.

30. Article conforme à l'une des revendications 16 à 25, dans lequel l'indice de fluidité à chaud du composant (ii), s'il est présent, mesuré selon le procédé ASTM D-1238-01 à 190 °C sous une charge de 2,16 kg, vaut entre 0,3 et 50.

31. Article conforme à l'une des revendications 16 à 30, dans lequel l'indice de fluidité à chaud de la composition de polymères, mesuré selon le procédé ASTM D-1238-01 à 230 °C sous une charge de 2,16 kg, vaut entre 0,1 et 500 grammes par 10 minutes.

32. Article conforme à l'une des revendications 16 à 30, dans lequel l'indice de fluidité à chaud de la composition de polymères, mesuré selon le procédé ASTM D-1238-01 à 230 °C sous une charge de 2,16 kg, vaut entre 0,2 et 150 grammes par 10 minutes.

33. Article conforme à l'une des revendications 16 à 30, dans lequel l'indice de fluidité à chaud de la composition de polymères, mesuré selon le procédé ASTM D-1238-01 à 230 °C sous une charge de 2,16 kg, vaut entre 0,3 et 100 grammes par 10 minutes.

34. Article conforme à l'une des revendications 21 à 24, dans lequel la vitesse de transmission de l'oxygène à travers la paroi de la bouteille ou du récipient, déterminée à 23 °C et sous 40 % d'humidité relative à l'aide d'un appareil MOCON, est réduite d'un facteur supérieur à 5 par rapport à un récipient non revêtu.

35. Article conforme à l'une des revendications 21 à 24, dans lequel la vitesse de transmission de l'oxygène à travers la paroi de la bouteille ou du récipient, déterminée à 23 °C et sous 40 % d'humidité relative à l'aide d'un appareil MOCON, après remplissage du récipient avec un liquide chauffé à 85 °C, puis refroidissement jusqu'à température ambiante, est réduite d'un facteur supérieur à 2 par rapport à un récipient non revêtu, rempli d'un liquide chauffé à 85 °C et laissé ensuite se refroidir jusqu'à température ambiante.

36. Article conforme à la revendication 34, dans lequel la vitesse de transmission de l'oxygène à travers la paroi de la bouteille ou du récipient, déterminée à 23 °C et sous 40 % d'humidité relative à l'aide d'un appareil MOCON, est réduite d'un facteur supérieur à 18 par rapport à celle d'un récipient non revêtu.

37. Article conforme à la revendication 35, dans lequel la vitesse de transmission de l'oxygène à travers la paroi de la bouteille ou du récipient, déterminée, à 23 °C et sous 40 % d'humidité relative à l'aide d'un appareil MOCON, après remplissage du récipient avec un liquide chauffé à 85 °C, puis refroidissement jusqu'à température ambiante, est réduite d'un facteur supérieur à 10 par rapport à un récipient non revêtu, rempli d'un liquide chauffé à 85 °C et laissé ensuite se refroidir jusqu'à température ambiante.

Fig. 1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0310012 A
- WO 0066804 A
- US 20040149225 A1
- WO 2004033509 A1
- US 5494712 A
- US 5433786 A
- WO 2004033509 A2
- US 6112695 A

**Non-patent literature cited in the description**

- Macromolecular Physics. **B. WUNDERLICH.** Crystal Melting. Academic Press, 1960, vol. 3, 48
- **T. G. SCHOLTE ; N. L. J. MEIJERINK ; H. M. SCHOFFELEERS ; A. M. G. BRANDS.** *J. Appl. Polym. Sci.,* 1984, vol. 29, 3763-3782
- **E. P. OTOCKA ; R. J. ROE ; N. Y.HELLMAN ; P. M. MUGLIA.** *Macromolecules,* 1971, vol. 4, 507